(19) Europäisches Patentamt
European Patent Office
Office européen des brevets

(11) **EP 1 867 756 A2**

(12) **EUROPEAN PATENT APPLICATION**

(43) Date of publication:
**19.12.2007 Bulletin 2007/51**

(51) Int Cl.:
*C23C 30/00* (2006.01)      *C23C 16/36* (2006.01)
*C23C 16/40* (2006.01)      *C23C 16/56* (2006.01)
*B24C 1/08* (2006.01)

(21) Application number: **07109595.4**

(22) Date of filing: **05.06.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **15.12.2006 SE 0602723**
**16.06.2006 WOPCT/SE2006/000736**

(71) Applicant: **Sandvik Intellectual Property AB**
**811 81 Sandviken (SE)**

(72) Inventors:
 • **Karlsson, Anders**
 **SE-114 41, Stockholm (SE)**

 • **Dahl, Katarina**
 **SE-811 36, Sandviken (SE)**
 • **Kjellgen, Jan**
 **SE 164 38 Kista, Sweden (SE)**
 • **Littecke, Peter**
 **SE-141 43, Huddinge (SE)**
 • **Anderson, Gunilla**
 **191 41 Sollentuna (SE)**

(74) Representative: **Hägglöf, Henrik**
 **Sandvik Intellectual Property AB**
 **811 81 Sandviken (SE)**

(54) **Coated cutting tool insert**

(57)     The present invention relates to a CVD-coated cutting tool insert with improved toughness properties having the ability to withstand high temperatures without sacrificing edge line security. The insert coating comprises a $TiC_xN_y$-layer with a low tensile stress level of 50-500 MPa and an $\alpha$-$Al_2O_3$-layer with a high surface smoothness with a mean Ra < 0.12 $\mu$m as measured by AFM-technique, obtained by subjecting the coating to an intensive wet blasting operation.

**Fig. 1**

EP 1 867 756 A2

**Description**

The present invention relates to a high performance coated cutting tool insert particularly useful for turning in low alloyed steel, carbon steel and tough hardened steels in the area from finishing to roughing in wet and dry conditions at high cutting speed, having the ability to withstand high temperatures without sacrificing edge security. The insert is based on WC, cubic carbides and a Co-binder phase with a cobalt enriched surface zone giving the cutting insert an excellent resistance to plastic deformation and a high toughness performance. Furthermore, the coating comprises a number of wear resistance layers which have been subjected to a surface post treatment giving the tool insert a surprisingly improved cutting performance.

The majority of today's cutting tools are based on a cemented carbide insert coated with several hard layers like TiC, $TiC_xN_y$, TiN, $TiC_xNyO_z$ and $Al_2O_3$. The sequence and the thickness of the individual layers are carefully chosen to suit different cutting application areas and work-piece materials. The most frequent employed coating techniques are Chemical Vapour Deposition (CVD) and Physical Vapour Deposition (PVD). CVD-coated inserts in particular have a tremendous advantage in terms of flank and crater wear resistance over uncoated inserts.

The CVD technique is conducted at a rather high temperature range, 950-1050 °C. Due to this high deposition temperature and to a mismatch in the coefficients of thermal expansion between the deposited coating materials and the cemented carbide tool insert, CVD can lead to coatings with cooling cracks and high tensile stresses (sometimes up to 1000 MPa). The high tensile stresses can under some cutting conditions be a disadvantage as it may cause the cooling cracks to propagate further into the cemented carbide body and cause breakage of the cutting edge.

In the metal cutting industry there is a constant striving to increase the cutting condition envelope, i.e., the ability to withstand higher cutting speeds without sacrificing the ability to resist fracture or chipping during interrupted cutting at low speeds.

Important improvements in the application envelope have been achieved by combining inserts with a binder phase enriched surface zone and optimized, thicker coatings.

However, with an increasing coating thickness, the positive effect on wear resistance is out-balanced by an increasing negative effect in the form of an increased risk of coating delamination and reduced toughness making the cutting tool less reliable. This applies in particular to softer work piece materials such as low carbon steels and stainless steels and when the coating thickness exceeds 5-10 $\mu$m. Further, thick coatings generally have a more uneven surface, a negative feature when cutting smearing materials like low carbon steels and stainless steel. A remedy can be to apply a post smoothing operation of the coating by brushing or by wet blasting as disclosed in several patents, e.g., EP 0 298 729, EP 1 306 150 and EP 0 736 615. In US 5,861,210 the purpose has, e.g., been to achieve a smooth cutting edge and to expose the $Al_2O_3$ as the outermost layer on the rake face leaving the TiN on the clearance side to be used as a wear detection layer. A coating with high resistance to flaking is obtained.

Every post treatment technique that exposes a surface, e.g., a coating surface to a mechanical impact as, e.g., wet or dry blasting will have some influence on the surface finish and the stress state ($\sigma$) of the coating.

An intense blasting impact may lower the tensile stresses in a CVD-coating, but often this will be at the expense of lost coating surface finish by the creation of ditches along the cooling cracks or it can even lead to delamination of the coating.

A very intensive treatment may even lead to a big change in the stress state, e.g., from highly tensile to highly compressive as disclosed in EP-A-1 311 712, in which a dry blasting technique is used.

It has now surprisingly been found that a cutting tool insert having a combination of a certain cemented carbide substrate composition and a certain coating structure and thickness, and being post treated by wet-blasting under controlled conditions obtains excellent cutting properties over a broader range of applications than prior art cutting tool inserts.

The cobalt binder phase is highly alloyed with W. The content of W in the binder phase can be expressed as the CW-ratio:

$$\texttt{CW-ratio = M}_s\texttt{/(wt-\%Co*0.0161)}$$

wherein $M_s$ = measured saturation magnetization in $hAm^2/kg$ and wt-% Co is the cobalt content in the cemented carbide. A low CW-ratio corresponds to a high W-content in the Co binder phase. The employed post treatment will give the coating a favourable tensile stress level, the $Al_2O_3$-layer a certain important crystallographic feature and a top surface with an excellent surface finish.

The mentioned combination with the blasting technique effectively expands the limitations of what coating thickness that can be applied without performance penalty. As a result of the invention application areas of unsurpassed width is now possible. The significant improvements achieved with respect to toughness behaviour and coating adhesion was surprising.

To significantly change the stress state of a coating by blasting, the blasting media, e.g., $Al_2O_3$ grits have to strike the coating surface with a high impulse. The impact force can be controlled by, e.g., the blasting pulp pressure (wet blasting), the distance between blasting nozzle and coating surface, grain size of the blasting media, the concentration of the blasting media and the impact angle of the blasting jet.

It is an object of the present invention to provide CVD-coated tool inserts with improved toughness properties having the ability to withstand high temperatures without sacrificing edge security or toughness.

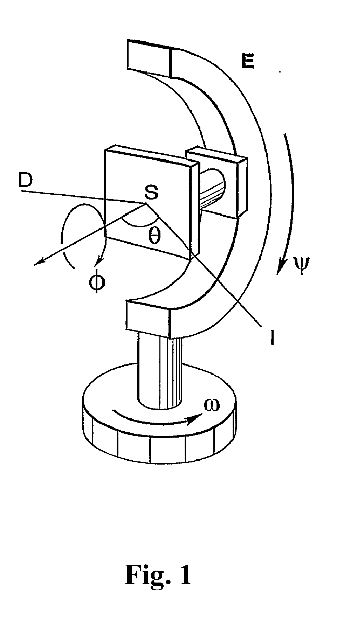

Fig. 1 shows a goniometer set-up for the evaluation of residual stress by X-ray measurements in which

E = Euler ¼-cradle

S = sample

I = incident X-ray beam

D = diffracted X-ray beam

$\theta$ = diffraction angle

$\omega = \theta$

$\psi$ = tilt angle along the Euler ¼-cradle

$\Phi$ = rotation angle around the sample axis

The present invention thus relates to coated cutting tool inserts comprising a body of generally polygonal or round shape having at least one rake face and at least one clearance face, comprising a coating and a carbide substrate. The body has a composition of 4.4-6.6, preferably 5.0-6.0, most preferably 5.0-5.8, wt-% Co, 4-8.5 wt-% cubic carbides, balance WC, preferably 85-91 wt-% WC, most preferably 87-90 wt-% WC, preferably having an average grain size of 1-4 $\mu$m, a CW-ratio in the range 0.78-0.92 and a surface zone depleted from the cubic carbides TiC, TaC and/or NbC.

Said surface zone depleted from cubic carbides has a thickness of from 10 $\mu$m, alternatively from 15 $\mu$m, or alternatively from 20 $\mu$m, to 40 $\mu$m, alternatively to 35 $\mu$m, alternatively to 30 $\mu$m, or alternatively to 25 $\mu$m.

The coating comprises at least one $TiC_xN_y$-layer and one well-crystalline layer of 100 % $\alpha$-$Al_2O_3$. One such $\alpha$-$Al_2O_3$-layer is the outermost visible layer on the rake face and along the cutting edge line and the layer can be intensively wet blasted with a sufficiently high energy to create tensile stress relaxation in both the $Al_2O_3$- and the $TiC_xN_y$-layers. The $Al_2O_3$ outermost layer has a very smooth surface at least in the chip contact zone on the rake face.

It has surprisingly been discovered that a significant improved toughness performance can be achieved if a coated cutting tool insert with a generally polygonal or round shape having at least one rake face and at least one clearance face, said insert being at least partly coated, produced to possess the following features:

- a penultimate $TiC_xN_y$-layer with a thickness of from 3 $\mu$m, preferably from 4 $\mu$m, more preferably from 5 $\mu$m, most preferably from 6 $\mu$m, to 15 $\mu$m, preferably to 13 $\mu$m, most preferably to 10 $\mu$m, where $x\geq0$, $y\geq0$ and $x+y=1$, preferably produced by MTCVD, with tensile stresses of 50-500 MPa, preferably 50-450 MPa, most preferably 50-400 MPa and

- an outer $\alpha$-$Al_2O_3$-layer with a thickness of from 3 $\mu$m, preferably from 3.5, most preferably from 4 $\mu$m, to 12 $\mu$m, preferably to 11 $\mu$m, most preferably to 10 $\mu$m, being the outermost layer on the rake face and along the edge line having a mean roughness Ra < 0.12 $\mu$m, preferably $\leq$ 0.10 $\mu$m, at least in the chip contact zone of the rake face, measured over an area of 10 $\mu$m x 10 $\mu$m by Atomic Force Microscopy (AFM) and an XRD-diffraction intensity (peak height minus background) ratio of I(012)/I(024) $\geq$1.3, preferably $\geq$ 1.5.

Preferably there is a thin 0.2-2 $\mu$m bonding layer of $TiC_xNyO_z$, $x\geq0$, $z>0$ and $y\geq0$ between the $TiC_xN_y$-layer and the $\alpha$-$Al_2O_3$-layer. The total thickness of the two layers is $\leq$25 $\mu$m.

Also according to the present invention, additional layers can be incorporated into the coating structure between the substrate and the layers, composed of metal nitrides and/or carbides and/or oxides with the metal elements selected from Ti, Nb, Hf, V, Ta, Mo, Zr, Cr, W and Al to a total coating thickness of <5 $\mu$m.

It is preferred to have some tensile stresses left in the $TiC_xN_y$-layer since it was found that such induced compressive stresses were not as stable with respect to temperature increase, which occurs in a cutting operation, as compared to if the coating has some tensile stresses still present. It was also found, that if compressive stresses were to be induced by blasting, a very high blasting impact force was required and under such conditions flaking of the coating frequently occurred along the cutting edge.

The residual stress, $\sigma$, of the inner $TiC_xN_y$-layer is determined by XRD measurements using the well known $\sin^2\psi$ method as described by I.C. Noyan, J.B. Cohen, Residual Stress Measurement by Diffraction and Interpretation, Springer-Verlag, New York, 1987 (pp 117-130). The measurements are performed using $CuK_\alpha$-radiation on the $TiC_xN_y$ (422) reflection with a goniometer setup as shown in Fig. 1. The measurements are carried out on an as flat surface as possible. It is recommended to use the side-inclination technique ($\psi$-geometry) with six to eleven $\psi$-angles, equidistant within a $\sin^2\psi$-range of 0 to 0.5 ($\psi$=45°). An equidistant distribution of $\Phi$-angles within a $\Phi$-sector of 90° is also preferred.

To confirm a biaxial stress state the sample shall be rotated for $\Phi=0°$ and $90°$ while tilted in $\psi$. It is recommended to investigate possible presence of shear stresses and therefore both negative and positive $\psi$-angles shall be measured. In the case of an Euler ¼-cradle this is accomplished by measuring the sample also at $\Phi=180°$ and $270°$ for the different $\psi$-angles. The $\sin^2\psi$ method is used to evaluate the residual stress preferably using some commercially available software such as DIFFRAC $^{Plus}$ Stress32 v. 1.04 from Bruker AXS with the constants Young's modulus, E=480 GPa and Poisson's ratio, V=0.20 in case of a MTCVD Ti(C,N)-layer and locating the reflection using the Pseudo-Voigt-Fit function. In the case of the following parameters are used: E-modulus=480 GPa and Poisson's ratio V=0.20. In case of a biaxial stress state the tensile stress is calculated as the average of the obtained biaxial stresses.

For the $\alpha$-$Al_2O_3$ it is in general not possible to use the $\sin^2\psi$ technique since the required high $2\theta$ angle XRD-reflections are often too weak. However, a useful alternative measure has been found which relates the state of the $\alpha$-$Al_2O_3$ to cutting performance.

For an $\alpha$-$Al_2O_3$ powder the diffraction intensity ratio I(012)/I(024) is close to 1.5. Powder Diffraction File JCPDS No 43-1484 states the intensities $I_0(012)=72$ and $I_0(024)=48$. For tensile stressed (with $\sigma$ about > 350 MPa) CVD $\alpha$-$Al_2O_3$-layers on cemented carbide, the intensity ratio I(012)/I(024) is surprisingly significantly less than the expected value 1.5, most often < 1. This may be due to some disorder in the crystal lattice caused by the tensile stresses. It has been found that when such a layer is stress released by, e.g., an intense blasting operation or if it has been completely removed from the substrate and powdered, the ratio I(012)/I(024) becomes closer, equal or even higher than 1.5. The higher the applied blasting force the higher the ratio will be. Thus, this intensity ratio can be used as an important state feature of an $\alpha$-$Al_2O_3$-layer.

According to the present invention a cutting tool insert is provided with a CVD-coating comprising a penultimate $TiC_xN_y$-layer and an outer $\alpha$-$Al_2O_3$-layer. The $Al_2O_3$ can be produced according to patent EP 603 144 giving the $Al_2O_3$-layer a crystallographic texture in 012-direction with a texture coefficient TC(012)>1.3, preferably > 1.5 or produced according to patents US 5,851,687 and US 5,702,808 giving a texture in the 110-direction with texture coefficient TC(110)> 1.5. However, in one embodiment the $Al_2O_3$ is produced according to patent EP 738 336 giving the $Al_2O_3$-layer a crystallographic texture in 104-direction with a texture coefficient TC(104)>1.5, preferably TC(104)>2.0, most preferably TC(104) >2.5. In order to obtain a high surface smoothness and low tensile stress level the coating is subjected to a wet blasting operation with a slurry consisting of F150 grits (FEPA-standard) of $Al_2O_3$ in water at an air pressure of 2.2-2.6 bar for about 10-20 sec/insert. The spray guns are placed approximately 100 mm from the inserts with a 90° spray angle. The insert has a different colour on the clearance side than on the black rake face. An outermost thin 0.1-2 $\mu$m colouring layer of TiN (yellow), $TiC_xN_y$ (grey or bronze), $ZrC_xN_y$ (reddish or bronze), where $x\geq0$, $y\geq0$ and $x+y=1$ or TiC (grey) is preferably deposited. The inserts are then blasted removing the top layer exposing the black $Al_2O_3$-layer. The coating on the rake face will have the low desired tensile stress 50-500 MPa while the clearance side will have high tensile stresses in the range 500-700 MPa, the tensile stress on the rake face being lower than the tensile stress on the clearance face, dependent on the choice of coating and the coefficient of Thermal Expansion (CTE) of the used cemented carbide insert. In an other embodiment of the invention the coated insert is blasted both on the rake face and the clearance side and a coloured heat resistant paint is sprayed on the clearance side or a coloured PVD layer is deposited there in order to obtain a possibility to identify a used cutting edge.

Example 1

The following samples were prepared:

A) Cemented carbide cutting inserts with the composition 5.5 wt-% Co, 2.9 wt-% TaC, 0.5 wt-% NbC, 1.9 wt-% TiC, 0.4 wt-% TiN, balance WC, having an average grain size of about 2 $\mu$m, with a surface zone, 18 $\mu$m thick, depleted from cubic carbides.

The saturation magnetization, $M_s$, was measured to be 0.077 $hAm^2/kg$ giving a CW-ratio of 0.87. The inserts were coated with a 0.5 $\mu$m thick layer of TiN using conventional CVD-technique at 930 °C followed by a 7 $\mu$m $TiC_xN_y$-layer employing the MTCVD-technique using $TiCl_4$, $H_2$, $N_2$ and $CH_3CN$ as process gases at a temperature of 885 °C. In subsequent process steps during the same coating cycle a layer of $TiC_xO_z$ about 0.5 $\mu$m thick was deposited at 1000 °C using $TiCl_4$, CO and $H_2$, and then the $Al_2O_3$-process was stared up by flushing the reactor with a mixture of 2 % $CO_2$, 3.2 % HCl and 94.8 % $H_2$ for 2 min before a 7 $\mu$m thick layer of $\alpha$-$Al_2O_3$ was deposited. On top was a thin approx. 0.5 $\mu$m TiN layer deposited. The process conditions during the deposition steps were as below:

|  | TiN | $TiC_xN_y$ | $TiC_xO_z$ | $Al_2O_3$-start | $Al_2O_3$ |
|---|---|---|---|---|---|
| Step | 1 and 6 | 2 | 3 | 4 | 5 |
| $TiCl_4$ | 1.5 % | 1.4 % | 2 % |  |  |
| $N_2$ | 38 % | 38 % |  | balance |  |
| $CO_2$: |  |  |  | 2 % | 4 % |

(continued)

| | | TiN | TiC$_x$N$_y$ | TiC$_x$O$_z$ | Al$_2$O$_3$-start | Al$_2$O$_3$ |
|---|---|---|---|---|---|---|
| | Step | 1 and 6 | 2 | 3 | 4 | 5 |
| | CO | | | 6 % | | |
| | AlCl$_3$: | | | | | 3.2 % |
| | H$_2$S | - | | | | 0.3 % |
| | HCl | | | | 3.2 % | 3.2 % |
| | H$_2$: | balance | balance | balance | - | balance |
| | CH$_3$CN | - | 0.6 % | | | |
| | Pressure: | 160 mbar | 60 mbar | 60 mbar | 60 mbar | 70 mbar |
| | Temp.: | 930°C | 885°C | 1000°C | 1000°C | 1000°C |
| | Time: | 30 min | 4.5 h | 20 min | 2 min | 7 h |

Additional inserts were:

B) Cemented carbide cutting inserts of the same type as in A) differing only in TiC$_x$N$_y$- and $\alpha$-Al$_2$O$_3$-layer thickness, being 6 $\mu$m and 9 $\mu$m thick respectively, were manufactured using the same processing conditions except for the TiC$_x$N$_y$ and Al$_2$O$_3$ depositing times being 4 h and 10 h, respectively.

XRD-analysis of the deposited Al$_2$O$_3$-layer of the inserts according to A) and B) showed that it consisted only of the $\alpha$-phase with a texture coefficient TC(104)=2.6 defined as below:

$$TC(104) = \frac{I(104)}{I_o(104)} \left\{ \frac{1}{n} \sum \frac{I(hkl)}{I_O(hkl)} \right\}^{-1}$$

where

I(hkl) = measured intensity of the (hkl) reflection
I$_o$(hkl) = standard intensity of Powder Diffraction File JCPDS No 43-1484.
n = number of reflections used in the calculation
(hkl) reflections used are: (012), (104), (110), (113), (024), (116).

The coated inserts according to A) and B) were post treated by the earlier mentioned blasting method, blasting the rake face of the inserts, using a blasting pressure of 2.4 bar and an exposure time of 20 seconds.

The smoothness of the coating surface expressed as a well known roughness value Ra was measured by AFM on an equipment from Surface Imaging System AG (SIS). The roughness was measured on ten randomly selected plane surface areas (10$\mu$mx10$\mu$m) in the chip contact zone on rake face. The resulting mean value from these ten Ra values, MRa, was 0.11 $\mu$m.

X-ray Diffraction Analysis using a Bragg-Brentano diffractometer, Siemens D5000, was used to determine the I(012)/I(024)-ratio using Cu K$\alpha$-radiation.

The obtained I(012)/I(024)-ratio on the clearance side was about 1.2. A corresponding measurement on the rake face showed that the obtained I(012)/I(024)-ratio was about 2.1.

The residual stress was determined using $\psi$-geometry on an X-ray diffractometer Bruker D8 Discover-GADDS equipped with laser-video positioning, Euler 1/4-cradle, rotating anode as X-ray source (CuK$_\alpha$-radiation) and an area detector (Hi-star). A collimator of size 0.5 mm was used to focus the beam. The analysis was performed on the TiC$_x$N$_y$ (422) reflection using the goniometer settings 2e=126°, $\omega$=63° and $\Phi$=0°, 90°, 180°, 270°, Eight $\psi$ tilts between 0° and 70° were performed for each $\Phi$-angle. The sin$^2\psi$ method was used to evaluate the residual stress using the software DIFFRAC$^{plus}$ Stress32 v. 1.04 from Bruker AXS with the constants Young's modulus, E=480 GPa and Poisson's ratio, $\nu$=0.20 and locating the reflection using the Pseudo-Voigt-Fit function. A biaxial stress state was confirmed and the average value was used as the residual stress value. Measurements were carried out both on the rake face and the clearance side. The obtained tensile stress on the clearance side was about 630 MPa for the inserts according to A) and B). A corresponding measurement on the rake face showed that a tensile stress of about 370 MPa was obtained for the inserts according to A) and a tensile stress of about 380 MPa was obtained for the inserts according to B.

Example 2

Inserts A) and B) from Example 1 were tested and compared with commercially available, non-blasted inserts (high performance inserts in the P15 area) with respect to toughness in a longitudinal turning operation with interrupted cuts.

Material: Carbon steel SS1312.

Cutting data:

| Cutting speed = | 150 m/min |
| Depth of cut = | 1.5 mm |
| Feed = | Starting with 0.15 mm and gradually increased by 0.08 mm/min until breakage of the edge. |

10 edges of each variant were tested
Inserts style: CNMG120408-PM

Results:

| | Average feed at breakage (mm/rev) |
| --- | --- |
| Commercially available inserts | 0.206 |
| A) | 0.282 |
| B) | 0.240 |

Example 3

Inserts A) from Example 1 were tested and compared with the same commercially available inserts as in Example 2 with respect to resistance to gross plastic deformation in a facing operation of SS2541.

Cutting data:

| Cutting speed= | 200 m/min |
| Feed= | 0.35 mm/rev. |
| Depth of cut= | 2 mm |

Tool life criteria: flank wear >= 0.5 mm
Insert style: CNMG120408-PM

Results:

| | Number of machining cycles needed to reach tool life |
| --- | --- |
| Commercially available inserts | 59.5 |
| A) | 64 |

Example 4

Inserts A) and B) from Example 1 were tested and compared with the same commercially available inserts as in Example 2 with respect to resistance to gross plastic deformation in a facing operation of SS2541. The test comprised two different insert sizes, represented by two different insert styles: CNMG160612-PR (cutting edge length = 16 mm) and CNMG190612-PR (cutting edge length = 19 mm).

Cutting data:

| Cutting speed= | 220 m/min |
| Feed= | 0.35 mm/rev. |
| Depth of cut= | 3 mm |

Tool life criteria: flank wear >= 0.5 mm

Results:

| | Number of machining cycles needed to reach tool life | |
|---|---|---|
| | CNMG160612-PR | CNMG190612-PR |
| Commercially available inserts | 36 | 50 |
| A) | 52 | 72 |
| B) | 51 | 77 |

**Claims**

1. A coated cutting tool insert of cemented carbide comprising a body of generally polygonal or round shape having at least one rake face and at least one clearance face c h a r a c t e r i s e d in said insert having a composition of 4.4-6.6, preferably 5.0-6.0, most preferably 5.0-5.8, wt-% Co, 4-8.5 wt-% cubic carbides, balance WC, a CW-ratio in the range 0.78-0.92 and having a surface zone of a thickness of 10 to 40 $\mu$m, depleted from the cubic carbides TiC, TaC and/or NbC, said insert being at least partly coated with a 10-25 $\mu$m thick coating including at least one layer of $TiC_xN_y$, where x≥0, y≥0 and x+y=1, preferably $TiC_xN_y$ deposited by MTCVD, and an $\alpha$-$Al_2O_3$-layer being the outer layer at least on the rake face, and that on said at least one rake face

   - the $TiC_xN_y$-layer having a thickness of from 3 $\mu$m, preferably from 4 $\mu$m, more preferably from 5 $\mu$m, most preferably from 6 $\mu$m, to 15 $\mu$m, preferably to 13 $\mu$m, most preferably to 10 $\mu$m, and a tensile stress level of 50-500 MPa, preferably 50-450 MPa and
   - the $\alpha$-$Al_2O_3$-layer having a thickness of from 3 $\mu$m, preferably from 3.5, most preferably from 4 $\mu$m, to 12 $\mu$m, preferably to 11 $\mu$m, most preferably to 10 $\mu$m, being the outermost layer with an XRD-diffraction intensity ratio I(012)/I(024) ≥1.3, preferably ≥1.5 and having a mean Ra value MRa < 0.12 $\mu$m, preferably ≤ 0.10 $\mu$m, at least in the chip contact zone on the rake face, and on said at least one clearance face
   - the $TiC_xN_y$-layer having a tensile stress in the range 500-700 MPa and that
   - the $\alpha$-$Al_2O_3$-layer has an XRD-diffraction intensity ratio I(012)/I(024)<1.5, preferably covered with a thin 0.1-2 $\mu$m TiN, $TiC_xN_y$, $ZrC_xN_y$ or TiC layer giving the insert a different colour on that face
   or on said at least one rake face and said at least one clearance face
   - the $TiC_xN_y$-layer having a thickness of from 3 $\mu$m, preferably from 4 $\mu$m, more preferably from 5 $\mu$m, most preferably from 6 $\mu$m, to 15 $\mu$m, preferably to 13 $\mu$m, most preferably to 10 $\mu$m, and a tensile stress level of 50-500 MPa, preferably 50-450 MPa and
   - the $\alpha$-$Al_2O_3$-layer having a thickness of from 3 $\mu$m, preferably from 3.5, most preferably from 4 $\mu$m, to 12 $\mu$m, preferably to 11 $\mu$m, most preferably to 10 $\mu$m, having an XRD-diffraction intensity ratio I(012)/I(024) ≥1.3, preferably ≥1.5 and being the outermost layer on the rake face with a mean Ra value MRa < 0.12 $\mu$m, preferably ≤ 0.10 $\mu$m, at least in the chip contact zone on the rake face, and on said clearance face the outermost layer consists of a coloured heat resistant paint or a coloured PVD-layer.

2. A cutting tool insert according to the preceding claim **characterized in** having a thin 0.2-2 $\mu$m $TiC_xN_yO_z$ bonding

layer, $x \geq 0$, $z > 0$ and $y \geq 0$, between the $TiC_xN_y$- and the $Al_2O_3$-layer.

3.  A cutting tool insert according to any of the preceding claims **characterized in** the $\alpha$-$Al_2O_3$-layer having a texture in the 104-direction with a texture coefficient TC (104) >1 .5.

4.  A cutting tool insert according to claim 3 **characterized in** the $\alpha$-$Al_2O_3$-layer having a texture in the 104-direction with a texture coefficient TC(104)>2.0.

5.  A cutting tool insert according to claim 4 **characterized in** the $\alpha$-$Al_2O_3$-layer having a texture in the 104-direction with a texture coefficient TC(104)>2.5.

6.  A cutting tool insert according to any of the preceding claims **characterized in** the $\alpha$-$Al_2O_3$-layer having a texture in the 012-direction with a texture coefficient TC(012)>1.3, preferably TC(012)> 1.5.

7.  A cutting tool insert according to any of the preceding claims **characterized in** the $\alpha$-$Al_2O_3$-layer having a texture in the 110-direction with a texture coefficient TC (110) >1 .5.

8.  A cutting tool insert according to any of the preceding claims **characterized in** the coating containing additional layers composed of metal nitrides and/or carbides and/or oxides with the metal elements selected from Ti, Nb, Hf, V, Ta, Mo, Zr, Cr, W and Al to a total layer thickness of <5 $\mu$m.

9.  A cutting tool insert according to any of the preceding claims **characterized in that** said surface zone depleted from cubic carbides has a thickness of from 15 $\mu$m, or alternatively from 20 $\mu$m, to 35 $\mu$m, alternatively to 30 $\mu$m, or alternatively to 25 $\mu$m.

10. A cutting tool insert according claim 9 **characterized in that** said surface zone depleted from cubic carbides has a thickness of from 15 $\mu$m to 25 $\mu$m.

**Fig. 1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 0298729 A
- EP 1306150 A
- EP 0736615 A
- US 5861210 A
- EP 1311712 A
- EP 603144 A
- US 5851687 A
- US 5702808 A
- EP 738336 A

### Non-patent literature cited in the description

- **I.C. NOYAN ; J.B. COHEN.** Residual Stress Measurement by Diffraction and Interpretation. Springer-Verlag, 1987, 117-130